(19) Europäisches Patentamt / European Patent Office / Office européen des brevets

(11) **EP 4 249 927 B1**

(12) **EUROPEAN PATENT SPECIFICATION**

(45) Date of publication and mention
of the grant of the patent:
**06.08.2025 Bulletin 2025/32**

(21) Application number: **22305350.5**

(22) Date of filing: **23.03.2022**

(51) International Patent Classification (IPC):
**G01R 31/28** (2006.01)   **G01R 31/26** (2020.01)

(52) Cooperative Patent Classification (CPC):
**G01R 31/2621; G01R 31/2608; G01R 31/2642;
G01R 31/2817**

(54) **GATE OXIDE DETERIORATION ESTIMATION FOR POWER SEMICONDUCTORS**

SCHÄTZUNG DER GATE-OXID-VERSCHLECHTERUNG FÜR LEISTUNGSHALBLEITER

ESTIMATION DE LA DÉTÉRIORATION D'OXYDE DE GRILLE POUR SEMI-CONDUCTEURS DE PUISSANCE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**27.09.2023 Bulletin 2023/39**

(73) Proprietors:
• **MITSUBISHI ELECTRIC CORPORATION**
**Chiyoda-ku**
**Tokyo 100-8310 (JP)**
Designated Contracting States:
**AL AT BE BG CH CY CZ DE DK EE ES FI GB GR
HR HU IE IS IT LI LT LU LV MC MK MT NL NO PL
PT RO RS SE SI SK SM TR**

• **Mitsubishi Electric R&D Centre Europe B.V.**
**1119 NS  Schiphol Rijk Amsterdam (NL)**
Designated Contracting States:
**FR**

(72) Inventors:
• **BRANDELERO, Julio**
**35708 Rennes Cedex 7 (FR)**
• **DEGRENNE, Nicolas**
**35708 Rennes Cedex 7 (FR)**

(74) Representative: **Plasseraud IP**
**104 Rue de Richelieu**
**CS92104**
**75080 Paris Cedex 02 (FR)**

(56) References cited:
**JP-A- H09 246 340    US-A- 5 904 490**

**Description**

**Technical Field**

This disclosure pertains to the field of monitoring of power semiconductors during operational service.

**Background Art**

To monitor and estimate the threshold voltage shift during the life of a semiconductor is a classical activity to evaluate the Bias Temperature Instability (BTI) of such components. It is known to monitor BTI in a power semiconductor Metal-Oxide-Semiconductor type (MOS) or in paralleled connected power semiconductor MOS types or in a Metal-Insulator-Semiconductor type (MIS) or in paralleled connected power semiconductor MIS types, especially in power semiconductors devices/modules, like multichip power modules, for protection, condition and health monitoring.

Many BTI estimations methods are known but are not entirely satisfactory. It is possible to have static measurements to determine the threshold voltage shift. But it leads to underestimations of the threshold voltage value because of the recovery of the charge trapping between the end of the bias and the measurement. In such case, the threshold voltage of the power semiconductor can be measured when the converter is in idle state. It is possible to measure the transitory bias instability by making the time between the stress and the threshold voltage measurement inferior to 100ms. We can measure the shoot-through current and charge during switching transients. We can use the changing trend of a device's voltage, current, temperature with its degradation within accelerated aging tests for data collection and on-line degradation monitoring. Due to the settling time imposed by the monitoring system, accurate measurements require low switching frequency and high modulation indexes when monitoring. In this aim, a DPWM strategy (Digital Pulse Width Modulator) is proposed to monitor a device during a certain time where the power switch it is not switching, and hence, increase the accuracy of the measurements. All these known methods imply to stop the normal operation and/or stop the switching of the modules and/or have biases in certain situations.

The method disclosed in JP H09 246340 A involves measuring the flatband voltage of a semiconductor device different from a power semiconductor module and relates to evaluating the impurities that are diffused into a semiconductor substrate through a gate insulating film.

**Summary**

This disclosure improves the situation.

According to the invention, it is proposed a measurement method of a flatband voltage of a power semi-conductor module comprising at least one semiconductor element among a Metal-Oxide-Semiconductor element and a Metal-Insulator Semiconductor element during operational service. The method comprises:

a. applying a bias voltage to said module such that said module switches from an off-state to an on-state, or from an on-state to an off-state;

b. triggering a gate current $I_g$ injection from a current source to a gate of the module when an initial gate-emitter/source voltage is equal to a flatband voltage $V_{fb,h}$ of the module within +/-5V;

c. measuring the voltage $V_{ig}$ across the current source;

d. extracting of a flatband voltage $V_{fb,h+1}$ from the said measured voltage $V_{ig}$ across the current source

e. stopping said gate current $I_g$ injection

- when the absolute difference between the gate emitter/source voltage and the flatband voltage $V_{fb,h}$ becomes superior to a predefined limit; or

- when the gate current $I_g$ injection duration $t_{inj}$ exceeds a predetermined duration $t_{max}$; f. saving the extracted flatband voltage $V_{fb,h+1}$ value.

In another aspect of the invention, it is proposed a power semi-conductor module comprising a single Metal-Oxide-Semiconductor or a single Metal-Insulator-Semiconductor element or a set of Metal-Oxide-Semiconductor elements or a set of Metal-Insulator-Semiconductor elements or a combination of Metal-Oxide-Semiconductor elements and Metal-Insulator-Semiconductor elements, said module further comprising measuring means adapted to measure a voltage $V_{ig}$ across a current source and being arranged to implement the method of the invention.

In another aspect of the invention, it is proposed a computer software comprising instructions to implement the method of the invention when the software is executed by a processor. In another aspect of the invention, it is proposed a computer-readable non-transient recording medium on which a software is registered to implement the method of the invention when the software is executed by a processor.

The following features, can be optionally implemented, separately or in combination one with the others: The method further comprises:

- measuring a capacity $C_{meas}$ of the at least one semiconductor element, and wherein

the extracted flatband voltage $V_{fb,h+1}$ is the measured voltage $V_{ig}$ across the current source triggered when a transition between a constant $C_{meas}$ to a variable $C_{meas}$ is detected from the capacity measurement.

The sign of the injected gate current $I_g$ depends on the ON/OFF state of the semiconductor element.

The injected gate current $I_g$ is negative and

the gate current $I_g$ injection is stopped when the measured voltage $V_{ig}$ achieves a predetermined negative voltage, the temporal derivative voltage $dV_{ig}/dt$ is calculated and stored in such a way that it can be used as an input parameter to reiterate the method.

If the calculated temporal derivative voltage $dV_{ig}/dt$ does not drop more than a predetermined relative value, the method is then reiterated with a positive injected gate current $I_g$.

The gate current $I_g$ injection triggering is made:

- after a time $t_p$ of the switching-off of the semiconductor element, and the extraction of a positive gate bias flatband voltage $V_{fb, h+1}$; and/or
- a time $t_n$ before the switching-on of the semiconductor element.

The flatband voltage $V_{fb,h+1}$ is extracted from the said measured voltage $V_{ig}$ across the current source at an instant when a gate current $I_g$ injection is triggered in response to a condition on a second temporal derivative $d^2V_{ig}/dt^2$ of a measured voltage $V_{ig}$.

The method further comprises:

- a bus voltage measurement before the flatband voltage $V_{fb,h+1}$ extraction, and
- a measurement of the duration of the ON state and/or of the duration of the OFF state before the flatband voltage $V_{fb,h+1}$ extraction.

The series of operations is reiterated at least one time such that to output a flatband evolution along time.

**Brief Description of Drawings**

Other features, details and advantages will be shown in the following detailed description and on the figures, on which:

Fig. 1

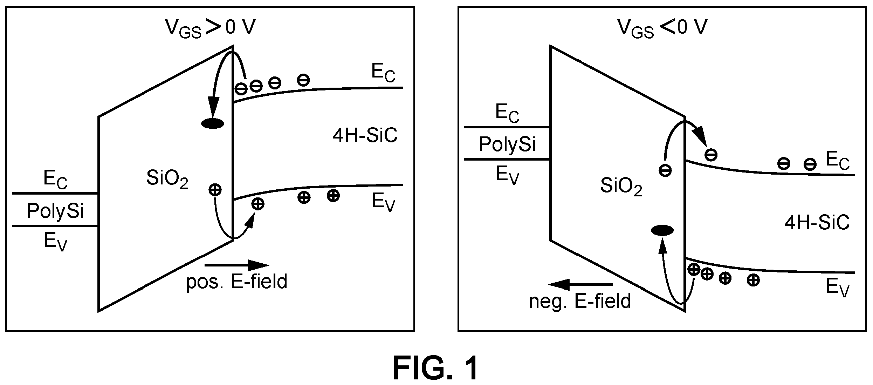

[Fig. 1] is a schematical representation of a physical phenomenon.

Fig. 2

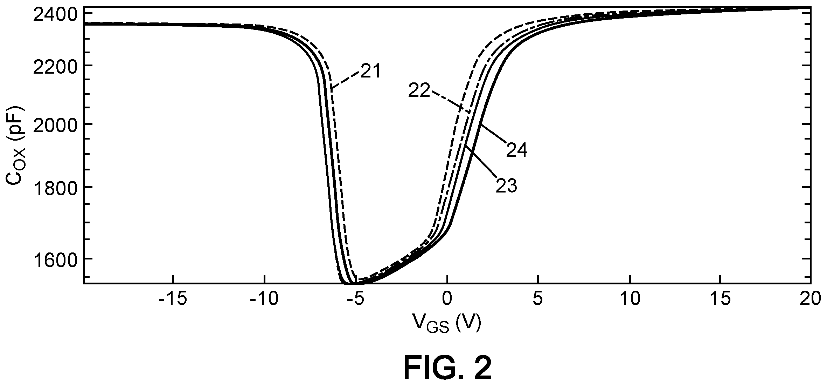

[Fig. 2] is a graphic view of the oxide Capacity in function of the Gate-to-Source Voltage $V_{GS}$ of semiconductor modules having different ages.

Fig. 3

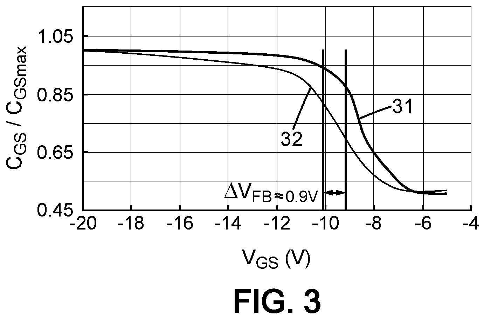

[Fig. 3] is a graphic view of the ratio of the Capacity of the oxide part on the maximum of said capacity in function of the Gate-to-Source Voltage $V_{GS}$ of a semiconductor module in different ages stages.

Fig. 4

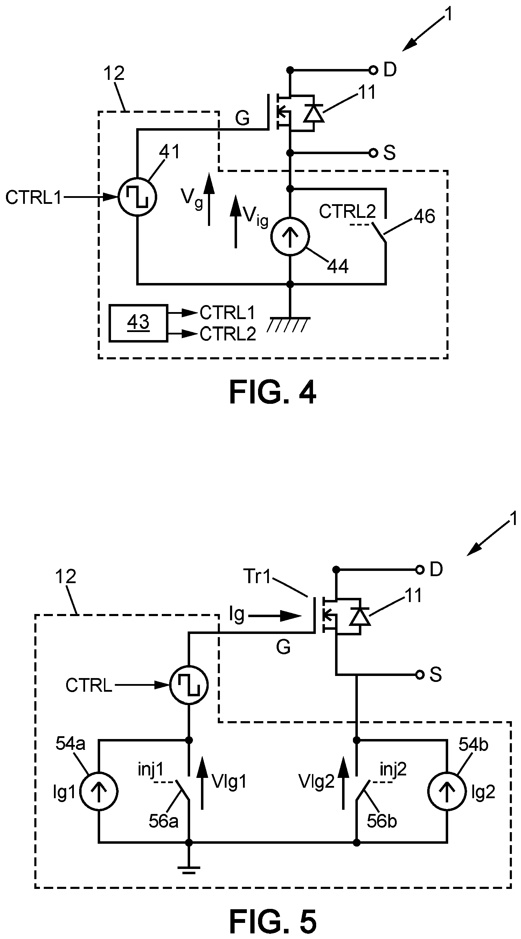

[Fig. 4] is a circuitry according to an embodiment.

Fig. 5
[Fig. 5] is a circuitry according to an embodiment.

Fig. 6

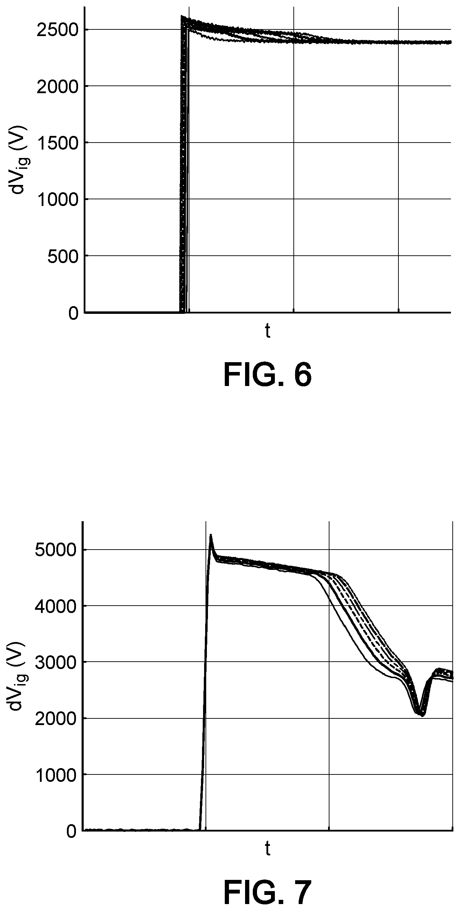

[Fig. 6] is a graphic view of some data obtained during an embodiment.

Fig. 7

[Fig. 7] is a graphic view of some data obtained during an embodiment.

**Fig. 8**

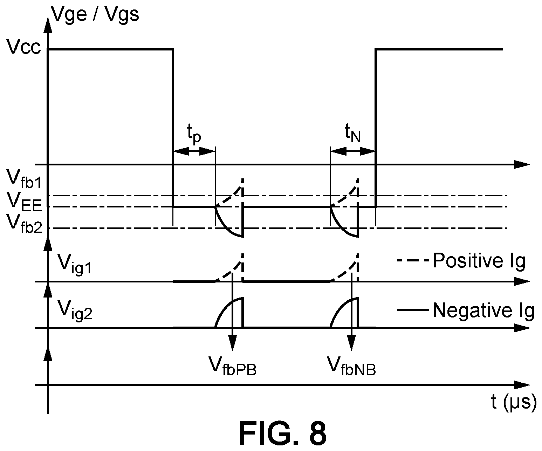

[Fig. 8] is a graphic view of some data obtained during an embodiment.

Fig. 9

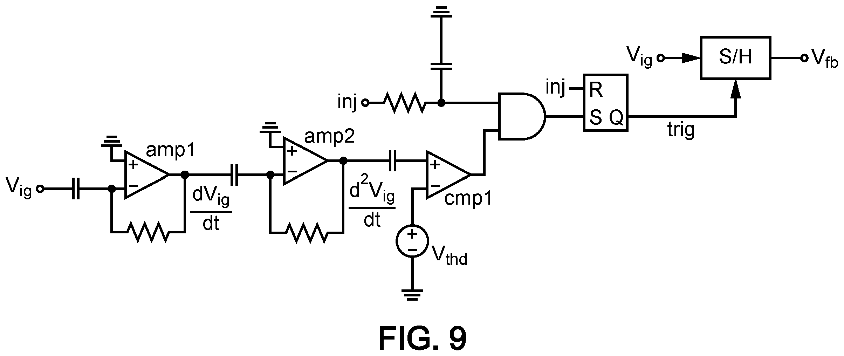

[Fig. 9] is an example of an equivalent circuit used to obtain some data according to an embodiment.

Fig. 10

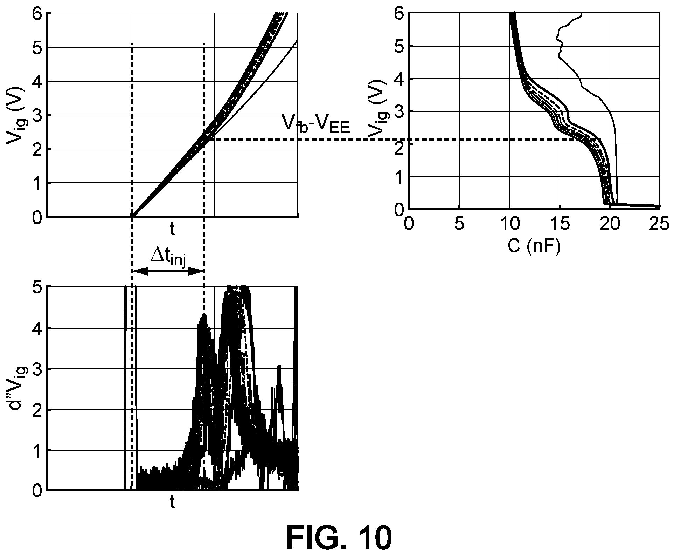

[Fig. 10] is a combination of various graphic views obtained in a first situation.

Fig. 11

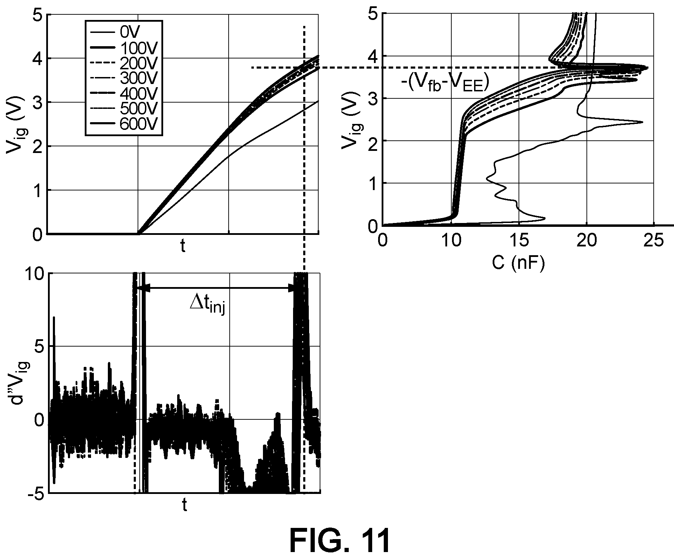

[Fig. 11] is a combination of various graphic views obtained in a second situation.

Fig. 12

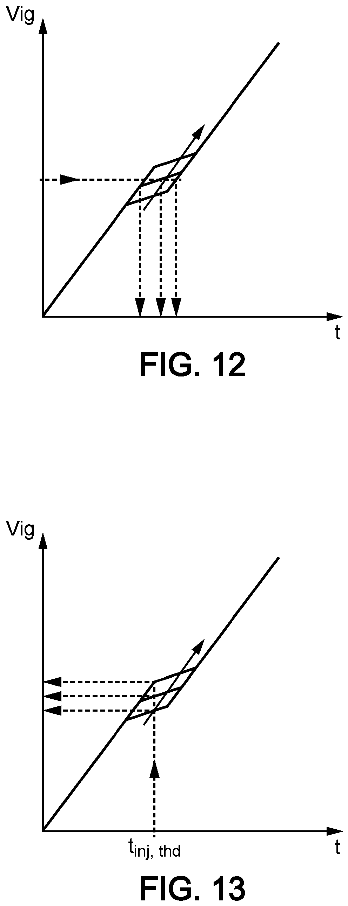

[Fig. 12] is a graphic view of some data obtained during according to an embodiment.

Fig. 13

[Fig. 13] is a graphic view of some data obtained during according to an embodiment.

Fig. 14

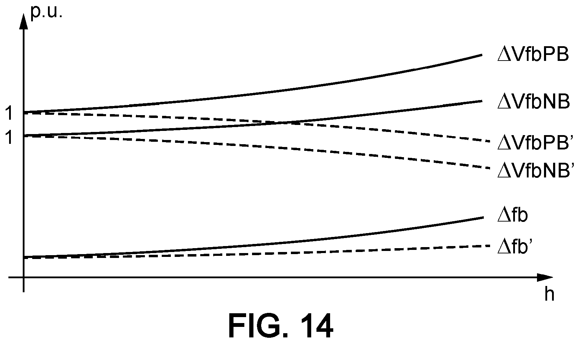

[Fig. 14] is schematic representation of the evolution of some index during the lifetime of a power semiconductor element.

## Main problems to solve

Bias temperature instability (BTI) is a reliability issue concerning the insulated gate power modules, such Metal-Oxide-Semiconductor-Field-Effect-Transistors (MOSFET), Insulated-Gate-Bipolar-Transistors (IGBT) and High-Electron-Mobility-Transistors (HEMT). In the SiC power semiconductor elements, this phenomenon is much more problematic during the device lifetime than in Si power semiconductor elements (approximately ten times higher), due to the reduced band offsets between the gate oxide and the power semiconductor occurrence and the carbon atoms degrading the atomically smooth $Si/SiO_2$ interface. The charge trapping also concerns the reliability in GaN HEMTs devices, due to the gate stack structure complexity.

The charge trapping can be a permanent or a transitory phenom which the main consequences of this reliability issue are:

i/ "On-state resistance RDS(on) increase" - leading to an over-loss dissipation on the devices/modules and an over-temperature during the power semiconductor elements operation which can be catastrophic for the integrity of the materials;

ii/ "Body diode threshold voltage" - leading to an over-loss dissipation on the element and an over-temperature during the power semiconductor operation;

iii/ "Off-state blocking leakage IDSS(off)" - that will generate extra losses on the element and can also lead to a catastrophic failure;

iv/ "Shoot-Through Currents" - given the change in the ON and OFF time delay. The initial dead time from power semiconductor cannot be enough to switch the series devices safely and create catastrophic short circuit failure.

In each previous concerns, the extra losses generated by the deterioration will increase the temperature of the power semiconductor which accelerates the degradation. In RF domain, the MOSFETs linearity degradation due to stress is also concerned.

Identifying the gate oxide degradation under on-line operation of the power semiconductor is a key parameter to assess the reliability of such devices: from a test and safety assessment point of view (including standards) and dispatch/maintenance of the power converter.

## Theory

The flatband voltage $V_{fb}$ is a voltage that when applied to a semiconductor element generates a flat energy band in the semiconductor and is determined by the following equation [Math. 1]:

[Math. 1]

$$V_{fb} = \Phi_{MS} - \frac{Q_{ox}}{C_{ox}} - \frac{1}{\varepsilon_{ox}} \int_{0}^{t_{ox}} \rho_{ox}(x) \cdot x \cdot dx$$

$\Phi_{MS}$ is the work function difference between the gate metal material and the semiconductor material. $C_{ox}$ is the thin oxide capacitance. $Q_{ox}$ is the total effective charge in the oxide. The last term of [Math. 1] is due to the charge density in the oxide.

Ones can note that the flatband voltage is affected by the presence of charges on the oxide-semiconductor interface. The charges presented in this interface are sensitive to the electric field formed on the channel. As the positive gate voltages generate a positive electrical field conducting to a negative charge accumulation on the oxide, the flatband voltage increases by the equation [Math. 1]. In an opposite way, as the negative gate voltages generate a negative electrical field conducting to a positive charge accumulation on the oxide, the flatband voltage decreases by the equation [Math. 1]. This phenomenon is called Bias Temperature Instability, or BTI. For a positive electrical field, it is called Positive Temperature Bias instability (PBTI). And for a negative electrical field, this is called Negative Temperature Bias Instability (NBTI).

[Fig. 1] is based on a figure published in the following paper: X. Zhong and e. al, "Bias Temperature Instability of Silicon Carbide Power MOSFET Under AC Gate Stresses" IEEE Transactions on Power Electronics, vol. 37, no. 2, pp. 1998-2008, Feb. 2022, doi: 10.1109/TPEL.2021.3105272. [Fig. 1] illustrates the above-described phenomena, the left part corresponding to a situation wherein the gate-source voltage $V_{GS}$ is superior to 0 V, while the right part corresponds to a situation wherein the gate-source voltage $V_{GS}$ is inferior to 0 V.

Despite the efforts during design to avoid the incorporation of charges on the oxide, during the lifetime of the power semiconductor element, positive or negative electrical fields will trap charges on the gate oxide. This phenomenon is hardly avoided in the case of SiC or GaN semiconductors materials where more interface states and fixed oxide charge appear after a high electric field application. The trapped charge is also significantly increased with a high switching frequency and/or by a hot device temperature.

One of the main consequences of the gate oxide deterioration is the evolution on the threshold voltage $V_{th}$ that is described as per following equations [Math. 2] and [Math. 3].

[Math. 2]

$$V_{th} = V_{fb} + 2\,\Phi_f + \frac{\sqrt{4 \cdot \varepsilon_s \cdot q \cdot N_a \cdot \Phi_f}}{C_{ox}}$$

[Math. 3]

$$\Phi_f = \frac{kT}{q} \ln \frac{N_a}{ni}$$

$N_a$ is the acceptor density in the substrate. $\varepsilon_s$ is the semiconductor dielectric constant. k is the Boltzmanns constant. T is the temperature. ni is the intrinsic carrier concentration. $C_{ox}$ is the oxide capacitor value.

As the gate and the substrate doping and the oxide thickness are not affected by the voltage bias stress, the noticeable change on the threshold voltage $V_{th}$ is related to the changes on the oxide charges and then can be monitored only by the measurement of the flatband voltage $V_{fb}$ as per following equation [Math. 4].

[Math. 4]

$$\Delta V_{th} = V_{th(fresh)} - V_{th(stress)} = V_{fb(fresh)} - V_{fb(stress)}$$

In order to measure the flatband voltage $V_{fb}$, the variation of the injected gate charge $dQ_g$ by the variation of the gate voltage $dV_g$ can be applied as the following equation [Math. 5], for $V_g < V_{th}$.

[Math. 5]

$$C = \frac{dQ_g}{dV_g} = min\left(\frac{1}{\sqrt{\frac{1}{C_{ox}^2} + \frac{2(V_g - V_{fb})}{\varepsilon_s \cdot q \cdot N_a}}}, C_{ox}\right)$$

This is given by the fact that for a $V_g$ superior to the flatband voltage $V_{fb,}$ the equivalent capacitor C is the series connection between the oxide capacitor and the depletion capacitor. When the gate voltage $V_g$ is inferior to the flatband voltage $V_{fb,}$ the capacitor C is only related to the gate oxide capacitor. Thus, the transition between a constant C to a variable C value on the gate voltage can be used as an indicator of the flatband voltage $V_{fb}$. This is illustrated by [Fig. 2] and [Fig. 3].

[Fig. 2] is based on a figure published in the following paper: M. Farhadi, F. Yang, S. Pu, B. T. Vankayalapati and B. Akin, "Temperature-Independent Gate-Oxide Degradation Monitoring of SiC MOSFETs Based on Junction Capacitances" in IEEE Transactions on Power Electronics, vol. 36, no. 7, pp. 8308-8324, July 2021, do. Each curve represents the oxide capacity in function of the Gate-to-Source voltage $V_{GS}$. Each curve corresponds to a situation with a known age of the power semiconductor element:

- curve 21: 10 hours
- curve 22: 100 hours
- curve 23: 200 hours
- curve 24: 300 hours.

As we can see on [Fig. 2], there is a sensitive area to aging, here approximately between -10 and -5 Volts that comprises the flatband voltage: The oxide capacity is highly dependent from the age of the component.

[Fig. 3] is based on a figure published in the following paper: S. Mbarek, F. Fouquet, P. Dherbecourt, M. Masmoudi and O. Latry, "Gate oxide degradation of SiC MOSFET under short-circuit aging tests" Microelectronics Reliability, vol. 64, no. https://doi.org/10.1016/j.microrel.2016.07.132., pp. 415-418, 2016. Each curve represents the ratio of the gate-source capacity $C_{GS}$ on its maximum $C_{GSmax}$ in function of the Gate-to-Source voltage $V_{GS}$. The curve 31 corresponding to measures made before aging of the component while the curve 32 corresponds to measures made after aging at 250 $\mu$s of the same component. The difference between the two corresponding flatband voltages $V_{fb}$ is superimposed on the curves 31, 32, here with a value of approximately 0.9 Volts ($\Delta V_{fb}$).

**Description of Embodiments**

In the following, power semi-conductor modules 1 are assembly comprising a single Metal-Oxide-Semiconductor (MOS) or a single Metal-Insulator-Semiconductor (MIS) element or a set of combined MOS and/or MIS elements. Even if the module 1 comprises a plurality of MOS or MIS elements, there are considered as single one in the following: there is a common gate G, a common source S and a common drain D. For this reason, it is referred to a single gate, a single source and a single drain in the following without distinction of embodiments with a single one or a plurality of MOS elements. The word "power" is used in its general meaning of the technical field of energy conversion (power electronics).

An aim of the following method is to estimate the Bias Temperature Instability (BTI) of a power semi-conductor module 1 in order to detect a deterioration of the gate oxide. Here, a method is proposed that can be used in operational conditions, typically not only on a test bench but when the module is integrated and interconnected in its operational and industrial environment.

The method comprises the following operations:

a. applying a bias voltage to the module 1 such that said module switches from an off-state to an on-state, or from an on-state to an off-state;

b. triggering a gate current $I_g$ injection from a current source 44 to a gate of the module when an initial gate-emitter/source voltage is equal to a flatband voltage $V_{fb,h}$ of the module within +/-5V, or less for example within +/-4V;

c. measuring the voltage $V_g$ across the current source;

d. extracting of a flatband voltage $V_{fb,h+1}$ from the said measured voltage $V_g$ across the current source

e. stopping said gate current $I_g$ injection when the absolute difference between the gate emitter/source voltage and the flatband voltage $V_{fb,h}$ becomes superior to a predefined limit or when the gate voltage $I_g$ injection duration $t_{inj}$ exceeds a predetermined duration $t_{max}$;

f. saving the extracted flatband voltage $V_{fb,h+1}$ value.

In an embodiment shown on [Fig. 4], the module 1 comprises a Metal-Oxide-Semiconductor (MOS) element or a Metal-Insulate-Semiconductor (MIS) element ("semiconductor element 11" or "transistor" hereinafter) and a control circuitry 12. The control circuitry 12 includes a gate driver voltage source 41 that controls the gate G of said semiconductor element between ON and OFF states following a control signal CTRL1, and a current source 44. The gate driver voltage value is referenced $V_g$. In the example, the (total) voltage values of the gate G during ON state is referenced $V_{cc}$ and is around 15V (classically between 10V and 20V) and the voltage values of the gate G during OFF state is referenced $V_{ee}$ and is around -5V (classically between -20V and 0V). The instants of the transition between the OFF and ON states are determined by the control signal CTRL1 sent by a controller 43 that alternates within a switching period. In some embodiments, the said controller 43 is a component of the module 1. In other embodiments, the said controller 43 is external to the module 1. The triggering of a gate current $I_g$ injection (operation b) is executed by the controller 43.

The current source 44 of the gate current $I_g$ injection is a DC current source. In the example, the current source has values from -100mA to 100mA. The module 1 comprises means able to control the injections of the currents on the gate G through a control signal CTRL2. In the example, such means comprises a switch 46. In various embodiments, such means can have other structure adapted to the architecture of the control circuitry 12, for example a set of parallel or series switches.

The voltage $V_{ig}$ across the current source 44 is representative on the gate-source voltage $V_{gs}$ of the semi-conductor element 11, as $V_{ig} = V_g - V_{gs}$ or $V_{ig} = V_{ee} - V_{gs}$. The voltage $V_{ig}$ across the current source 44 is measured (operation c), for example continuously. The flatband voltage $V_{fb}$ can be extracted from the variation of the injected gate charge, in this implementation example, the direct current $I_g$, by the variation of the gate voltage $V_{ig}$ on time t, as $V_g$ is constant during the measurement time t (equals to $V_{ee}$) according to the following [Math. 6] and [Math. 7].

[Math. 6]

$$\frac{dV_{gs}}{dt} = \frac{dV_{ig}}{dt}$$

[Math. 7]

$$C_{meas} = \frac{I_g}{dV_{ig}/dt}$$

The voltage $V_{ig}$ transition across the current source 44, between a constant measured capacity $C_{meas}$ to a variable measured capacity $C_{meas}$ value, is an indicator of the flatband voltage $V_{fb}$. In other words, the value of the voltage $V_{ig}(t)$ at the instant t when the measured capacity $C_{meas}$ becomes dependent can be used to estimate the value of the updated flatband voltage $V_{fb,h+1}$. For such implementation method, a stable derivative of measured capacity $C_{meas}$ trigger a sampling of the voltage $V_{ee} - V_{ig}$ as the estimated flatband voltage $V_{fb,h+1}$ (operation d).

In some embodiments, optional supplementary conditions can be imposed in order to ensure a good reliability of the estimation. For example, a minimum frequency of the AC signal and/or a minimum sampling rate can be set.

The current injection $I_g$ is stopped (operation e) when at least one of the following condition is reached:

- the absolute difference between the gate emitter/source voltage and the flatband voltage $V_{fb,h}$ becomes superior to a predetermined limit, for example 4V or 5V; or
- the gate current injection $I_g$ duration $t_{inj}$ exceeds a predetermined duration $t_{max}$, the value of the predetermined duration $t_{max}$ could be dependent from a known capacity, $C_{oxeq}$ (nominal or previously estimated or measured) of the semiconductor element 11.

In some embodiments, the two conditions are provided/configured such that the current injection is stopped as soon as one of the two conditions is reached. In various embodiments, only one of the two above conditions can be provided/configured, not the other one. In various embodiments, other conditions can be added. For example, the current injection can also be stopped when the derivative of the measured capacity $C_{meas}$ is stable.

In an example, for a current source $I_g$ of 10mA, a thin oxide capacitance $C_{oxeq}$ of 20nF, a gate voltage $V_{ee}$ during OFF state of -5V and an estimated flatband voltage $V_{fb}$ between -2V and -3V, the maximum time $t_{max}$ is determined according to the following [Math. 8], here $t_{max}$ being equal to 6 $\mu$s.

[Math. 8]

$$t_{max} \geq C_{oxeq} \cdot \frac{|V_{fb} - V_{ee}|}{I_g}$$

The updated value of the flatband voltage $V_{fb,h+1}$ corresponds to the voltage $V_g$ across the current source 44 measured at the same instant t of the current injection. In other words, operations d, e and f can be implemented for the same instant t.

The updated value of the flatband voltage $V_{fb,h+1}$ is saved on any adapted support in a manner to construct an history of the flatband voltage $V_{fb}$ values in function of time, along the operational life of the module 1.

In some embodiments, the above-described methods can form a loop: the same procedure is repeated several times after the first measurement that was stored in a memory in order to compare the flatband voltage evolution along time. In some embodiments, the method can be reiterated periodically, for example several hours/days.

In an embodiment shown on [Fig. 5], the module 1 comprises (at least) two current sources: a first current source 54a and a second current source 54b. The current sources 54a, 54b are arranged in series with the same semiconductor element 11 to feed it. The first current source 54a and the second source 54b are positive. Each current source 54a, 54b is in parallel with a respective switch 56a, 56b. Such a structure is an example that enables to control the sign of the injected gate current $I_g$.

In some embodiments, the series of operations (a to f) are repeated. In such a manner, a plurality of flatband voltages $V_{fb,h1}$, $V_{fb,h2}$, ..., $V_{fb,hN}$ is obtained and stored. The flatband values enables to output a flatband evolution along time as a relative damage indicator of the gate oxide.

In some embodiments, when the flatband voltage $V_{fb,h}$ is known and in the case of the flatband voltage $V_{fb,h}$ is higher than the OFF-state voltage $V_{EE}$, a current source provides a positive gate current $I_g$, for example here from the first source 54a. Otherwise, in the case of the flatband voltage $V_{fb}$ is lower than the OFF-state voltage $V_{EE}$, a current source provides a negative gate current $I_g$, for example here from the second source 54b. In other words, a negative gate current $I_g$ is injected to a gate of the module 1 when the initial gate-emitter/source voltage is superior to the flatband voltage $V_{fb,h}$. In the case of a positive gate current, the current source 54a is used to increase the gate voltage until, at least, the flatband voltage $V_{fb}$. The first current source 54a is connected between the gate driver voltage source and the emitter/source of the semiconductor device. In the case of a negative gate current, the flatband voltage $V_{fb}$ is lower than the OFF-state voltage $V_{EE}$, the current source 54b is used to decrease the gate voltage until the flatband voltage $V_{fb}$. The second current source 54b is placed between the emitter/source of the semiconductor element 11 and the gate driver voltage source.

In the following, a methodology is described to decide the usage of the current source when *a priori* flatband voltage $V_{fb}$ is not known. Firstly, a negative current source is used and the temporal derivative of $V_{ig}$ is performed (calculated and stored) as above explained. The injection is performed until the voltage $V_{ig}$ achieve a value close to the minimum allowed negative voltage of the power semiconductor element 11. For example, if the temporal derivative voltage ($dV_g/dt$) does not drop more than a predetermined relative value, for example 20%, the flatband voltage $V_{fb}$ is considered superior to the $V_{EE}$ value and then a positive current source should be used in the next switching periods, as shown on [Fig. 8]. In such an example, the extracting of the flatband voltage $V_{fb,h+1}$ from the said measured voltage $V_{ig}$ across the current source can be made at the instant when the next triggering of a gate current is launched.

The circuit implementation of the two current sources is shown on [Fig. 5]. It details the exact placement of the current sources 54a and 54b and the measurement of the voltage $V_{ig}$ used to estimate the flatband voltage $V_{fb}$.

The obtained waveforms are shown on [Fig. 6] and [Fig. 7]. In the examples of [Fig. 6] and [Fig. 7], the flatband voltage $V_{fb}$ is equal to 4 Volts. In [Fig. 6], the OFF-state voltage $V_{EE}$ is equal to 5 Volts. In [Fig. 7], the OFF-state voltage $V_{EE}$ is equal to 0 Volt. On [Fig. 8], the flatband voltage, represented by $V_{fb1}$, is higher than the $V_{EE}$. The current source $I_{g1}$ and the measured voltage $V_{ig1}$ are used to obtain the flatband voltage $V_{fb1}$ from the semiconductor element 11. Otherwise, for the case when the flatband voltage $V_{fb2}$ is lower than the $V_{EE}$, the current source $I_{g2}$ and the measured voltage $V_{ig2}$ are used to obtain the flatband voltage $V_{fb2}$ from the semiconductor element 11.

In some embodiments, the flatband voltage $V_{fb}$ is measured twice at the same switching period. This can be made in combination with the previous explanations. For this reason, it is also referred to [Fig. 8]. For example, a gate current $I_g$ injection triggering can be made (into the gate):

- after a time $t_p$ of the switching-off of the power semiconductor element 11, and the extraction (output) of a positive gate bias flatband voltage $V_{fb, h+1}$; and
- a time $t_n$ before the switching-on of the power semiconductor element 11, and the extraction (output) of a negative gate bias flatband voltage $V_{fb, h+1}$.

The respective flatband evolutions of said outputs can be used as a damage indicator of the gate oxide. The flatband voltage $V_{fb}$ can be tracked just after the positive gate bias $V_{fbPB}$ and at the end of the negative gate bias $V_{fbNB}$ for any possible OFF-state voltage value $V_{EE}$. Furthermore, a classical two levels gate driver implementation is compatible with such measurements. Consequently, few changes on a gate driver are necessary to measure the BTI according to such an embodiment.

In practice, a timer can be used to count the time $t_p$ between the falling edged of the gate voltage and the current injection. A signal can be used to trigger the time $t_n$. Or the previous switching pattern can be used to determine the total length of the OFF-state and the current injection is determined by triggering a timer that counts until the total previous OFF-state length minus the time $t_n$.

The negative gate bias value $V_{fbNB}$ can be acquired just before the turn-on, in such way, the monitoring can be made continually (for example within 10 μs between estimations) during the OFF-time and the last value before the turn-on is acquired. Advantageous, it only needs the internal gate control signals given that the gate signals are classically isolated from the main controller in known/existing modules.

In some embodiments, the flatband voltage $V_{fb,h+1}$ is extracted from the said measured voltage $Vi_g$ across the current source at an instant when a gate current $I_g$ injection is triggered in response to a condition on a second temporal derivative $d^2V_g/dt^2$ of a measured voltage $V_g$. In other words, the second derivative of the current source voltage is used to trigger the measurement of the current injection time $\Delta t$ that is the image of the flatband voltage $V_{fb}$ according to the following [Math. 9].

[Math.9]

$$V_{fb} = \Phi_{MS} - \frac{I_g \cdot \Delta t}{C_{ox}}$$

$\Phi_{MS}$ is the work function difference between the gate metal material and the semiconductor material.

To use a fast sampling rate ADCs *("Analogic-to-Digital Converter")* is possible but not necessary to detect the derivative of the equivalent capacitor: a simple analogue circuit can be used to trigger a fast counter. A higher current source value with a smaller measurement time is possible.

Referring to [Fig. 6] and [Fig. 7], the first peak of the second $V_{ig}$ derivative represents the instant when the current is injected on the gate. The second peak is used to trigger the $V_{ig}$ measurement through for example a "sample and hold". For the application, the second derivative is compared to a threshold value $V_{thd}$ equals to 2 Volts when a gain of 1e-6 is used. An example of a circuitry to use the second derivative to generate a trigger is presented in [Fig. 9]. [Fig. 10] shows graphically the methodology when a positive current source is used. [Fig. 11] shows graphically the methodology when a negative current source is used.

In some embodiments, the measurement of the voltage $V_g$ across the current source and the corresponding extraction of a flatband voltage $V_{fb,h+1}$ is made in function of:

- a duration of the injection $\Delta t_{inj}$ after the instant t when a current source voltage $V_{ig}$ reaches a threshold value $V_{thd}$ (see [Fig. 12]); or
- a current source voltage $V_{ig}$ after a predetermined duration $t_{inj,thd}$ of the gate current $I_g$ injection triggering (see [Fig. 13]).

In both cases, the measurement (a duration or a voltage) is the image of the flatband voltage $V_{fb}$. Doing this, a low-noise and a low-cost estimate of a parameter linked to the flatband voltage is established. In the case of an extraction based on a voltage measurement, no ADC is necessary. In the case of an extraction based on a time, no hardware is required to set the trigger.

In case of a current source threshold voltage value $V_{thd}$ is used to trigger the measurement of the injection time $\Delta t_{inj}$, the voltage value $V_{thd}$ is defined to be slightly above, respectively below, the expected increase, respectively decrease, of the flatband voltage drift. The injection time $\Delta t_{inj}$ value is measured and the flatband voltage $V_{fb}$ is then estimated by the following equation [Math. 10].

[Math. 10]

$$V_{fb} = \Phi_{MS} - \frac{I_g \cdot \Delta t_{inj}}{C_{ox}}$$

In case of a current injection threshold time $t_{inj,thd}$ is used to trigger the measurement of the current source voltage $V_{ig}$, the time delay value is defined to be slightly above, respectively below, the expected increase, respectively decrease, of the time to reach the flatband voltage $V_{fb}$.

In some embodiments, a bus voltage measurement is made before the flatband voltage $V_{fb}$ extraction. In some embodiments, a measurement of the duration of the ON state and/or of the duration of the OFF state is made before the flatband voltage $V_{fb}$ extraction. Thus, the evolution of the gate oxide deterioration can be observed as a function of specific operating parameters, such the bus voltage, the time of positive gate bias; the time of the negative gate bias; the switching frequency and/or the junction temperature.

**Industrial Applicability**

In some know methods, measuring a small signal capacitance using a C-V meter applies a DC bias voltage $V_g$ and a small sinusoidal signal to the MOS capacitor, and there is a measure of the capacitive current with an AC ammeter. In the above embodiments, there is an on-line flatband voltage $V_{fb}$ measurement during a Pulse-Width Modulation (PWM) field application. This method is applicable for any Metal Oxide Semiconductor (MOS) and Metal-Insulator-Semiconductor (MIS) type, for example MOSFETs and IGBTs transistors. The Bias Temperature Instability (BTI) is estimated in the insulated gate power semiconductor elements. The BTI is measured using the flatband indicator with an *in-situ* circuit measurement associated to the gate driver control of the power semiconductor elements during the operation of the power semiconductor in a field application.

The deterioration of the gate oxide can be detected during the power semiconductor operation within few microseconds after the end of the positive gate voltage bias and in the end of the negative gate voltage bias by the measurement of the flatband voltage $V_{fb}$. Thus, the gate charge trapping evolution and the gate charge trapping hysteresis can be evaluated along the lifetime of the power semiconductor elements in the field application. Furthermore, the current state of the semiconductor module is not changed during the measurements and does not prevent the normal operation of the module: it is transparent to the users. Finally, the reliability of the power semiconductor module is increased and guaranteed by the on-line measurements.

Caused by the positive/negative temperature bias instability (PBTI/NBTI), the evolution of the flatband voltage $V_{fb}$ that is representative of the evolution of the threshold voltage $V_{th}$ can be monitored along the lifetime of the power semiconductor module as shown in [Fig. 14].

This disclosure is not limited to the methods, modules, circuitries and computer software described here, which are only examples. The invention is defined by the independent claims.

**Reference Signs List**

- 1: module
- 11: semiconductor element
- 12: control circuitry
- 21: curve for an aging of 10 hours
- 22: curve for an aging of 100 hours
- 23: curve for an aging of 200 hours
- 24: curve for an aging of 300 hours
- 31: curve before aging
- 32: curve after aging at $250\mu s$
- 41: voltage source
- 43: control unit
- 44: current source
- 46: switch
- 54a: first current source
- 54b: second current source
- 56a: first switch
- 56b: second switch
- CTRL1: control signal
- CTRL2: control signal.

**Claims**

**1.** A measurement method of a flatband voltage of a power semi-conductor module (1) comprising at least one semiconductor element (11) among a Metal-Oxide-Semiconductor element and a Metal-Insulator Semiconductor element during operational service, said method comprising:

   a. applying a bias voltage to said module (1) such that said module switches from an off-state to an on-state, or from an on-state to an off-state;
   b. triggering a gate current $I_g$ injection from a current source (44) to a gate of the module when an initial gate-emitter/source voltage is equal to a flatband voltage $V_{fb,h}$ of the module within +/-5V;
   c. measuring the voltage $V_{ig}$ across the current source;
   d. extracting of a flatband voltage $V_{fb,h+1}$ from the said measured voltage $V_{ig}$ across the current source
   e. stopping said gate current $I_g$ injection

   - when the absolute difference between the gate emitter/source voltage and the flatband voltage $V_{fb,h}$ becomes superior to a predefined limit; or
   - when the gate current $I_g$ injection duration $t_{inj}$ exceeds a predetermined duration $t_{max}$;

   f. saving the extracted flatband voltage $V_{fb,h+1}$ value.

2. The method according to claim 1, further comprising:

   - measuring a capacity $C_{meas}$ of the at least one semiconductor element (11), and wherein

   the extracted flatband voltage $V_{fb,h+1}$ is the measured voltage $V_{ig}$ across the current source triggered when a transition between a constant $C_{meas}$ to a variable $C_{meas}$ is detected from the capacity measurement.

3. The method according to one of the preceding claims, wherein the sign of the injected gate current $I_g$ depends on the ON/OFF state of the semiconductor element (11).

4. The method according to claim 3, wherein

   the injected gate current $I_g$ is negative
   the gate current $I_g$ injection is stopped when the measured voltage $V_{ig}$ achieves a predetermined negative voltage,
   the temporal derivative voltage $dV_{ig}/dt$ is calculated and stored in such a way that it can be used as an input parameter to reiterate the method.

5. The method according to claim 4, wherein
   if the calculated temporal derivative voltage $dV_{ig}/dt$ does not drop more than a predetermined relative value, the method is then reiterated with a positive injected gate current $I_g$.

6. The method according to one of the preceding claims, wherein the gate current $I_g$ injection triggering is made:

   - after a time $t_p$ of the switching-off of the semiconductor element (11), and the extraction of a positive gate bias flatband voltage $V_{fb, h+1}$; and/or
   - a time $t_n$ before the switching-on of the semiconductor element (11).

7. The method according to one of the preceding claims, wherein the flatband voltage $V_{fb,h+1}$ is extracted from the said measured voltage $V_{ig}$ across the current source at an instant when a gate current $I_g$ injection is triggered in response to a condition on a second temporal derivative $d^2V_{ig}/dt^2$ of the measured voltage $V_{ig}$.

8. The method according to one of the preceding claims, further comprising:

   - a bus voltage measurement before the flatband voltage $V_{fb,h+1}$ extraction, and
   - a measurement of the duration of the ON state and/or of the duration of the OFF state before the flatband voltage $V_{fb,h+1}$ extraction.

9. The method according to one of the preceding claims, wherein the series of operations is reiterated at least one time so as to output a flatband evolution along time.

10. A power semi-conductor module (1) comprising a single Metal-Oxide-Semiconductor or a single Metal-Insulator-Semiconductor element or a set of Metal-Oxide-Semiconductor elements or a set of Metal-Insulator-Semiconductor elements or a combination of Metal-Oxide-Semiconductor elements and Metal-Insulator-Semiconductor elements, said module further comprising measuring means adapted to measure a voltage $V_{ig}$ across a current source and being arranged to implement the method according to one of claims 1 to 9.

11. Computer software comprising instructions to implement the method according to one of claims 1 to 9 when the software is executed by a processor.

12. Computer-readable non-transient recording medium on which a software is registered to implement the method according to one of claims 1 to 9 when the software is executed by a processor.

**Patentansprüche**

1. Messungsverfahren einer Flachbandspannung eines Leistungshalbleitermoduls (1), welches wenigstens ein Halbleiterelement (11) aus einem Metalloxid-Halbleiterelement und einem Metallisolator-Halbleiterelement während einem betriebsbereiten Service umfasst, wobei das Verfahren umfasst:

   a. Anlegen einer Vorspannung an dem Modul (1), sodass das Modul von einem Auszustand zu einem Anzustand oder von einem Anzustand zu einem Auszustand wechselt;
   b. Auslösen einer Gatestrom-$I_g$-Injektion von einer Stromquelle (44) zu einem Gate des Moduls, wenn eine initiale Gateemitter/-quellen-Spannung gleich einer Flachbandspannung $V_{fb,h}$ des Moduls innerhalb von +/- 5 V ist;
   c. Messen der Spannung $V_{ig}$ über die Stromquelle;
   d. Extrahieren einer Flachbandspannung $V_{fb,h+1}$ aus der gemessenen Spannung $V_{ig}$ über die Stromquelle;
   e. Stoppen der Gatestrom-$I_g$-Injektion,

      - wenn der absolute Unterschied zwischen der Gateemitter/-quellen-Spannung und der Flachbandspannung $V_{fb,h}$ höher als eine vorbestimmte Grenze wird; oder
      - wenn die Gatestrom-$I_g$-Injektiondauer $t_{inj}$ eine vorbestimmte Dauer $t_{max}$ überschreitet;

   f. Speichern des extrahierten Flachbandspannung-$V_{fb,h+1}$-Wertes.

2. Verfahren nach Anspruch 1, ferner umfassend:

   - Messen eine Kapazität $C_{meas}$ des wenigstens einen Halbleiterelements (11), und wobei die extrahierte Flachbandspannung $V_{fb,h+1}$ die gemessene Spannung $V_{ig}$ über die Stromquelle ist, welche ausgelöst wird, wenn ein Übergang zwischen einer konstanten $C_{meas}$ zu einer variablen $C_{meas}$ von der Kapazitätsmessung detektiert wird.

3. Verfahren nach einem der vorhergehenden Ansprüche, wobei das Zeichen des injizierten Gatestroms $I_g$ dem An-/Auszustand des Halbleiterelements (11) abhängt.

4. Verfahren nach Anspruch 3, wobei

   der injizierte Gatestrom $I_g$ negativ ist,
   die Gatestrom-$I_g$-Injektion gestoppt wird, wenn die gemessene Spannung $V_{ig}$ eine vorbestimmte negative Spannung erreicht,
   die Zeitableitungsspannung $dV_{ig}/dt$ in einer derartigen Weise berechnet und gespeichert ist, dass sie als ein Eingabeparameter verwendet werden kann, um das Verfahren zu wiederholen.

5. Verfahren nach Anspruch 4, wobei, wenn die berechnete Zeitableitungsspannung $dV_{ig}/dt$ nicht weiter als ein vorbestimmter relativer Wert absinkt, das Verfahren dann mit einem positiven injizierten Gatestrom $I_g$ wiederholt wird.

6. Verfahren nach einem der vorhergehenden Ansprüche, wobei das Gatestrom-$I_g$-Injektion-Auslösen erzeugt wird:

   - nach einer Zeit $t_p$ von dem Ausschalten des Halbleiterelements (11) und dem Extrahieren einer positiven Gate-Flachbandvorspannung $V_{fb,h+1}$; und/oder

- zu einer Zeit $t_n$ vor dem Anschalten des Halbleiterelements (11).

7. Verfahren nach einem der vorhergehenden Ansprüche, wobei die Flachbandspannung $V_{fb,h+1}$ von der gemessenen Spannung $V_{ig}$ über die Spannungsquelle zu einem Zeitpunkt extrahiert wird, wenn eine Gatestrom-$I_g$-Injektion als Antwort auf eine Kondition zu einer zweiten Zeitableitungsspannung $d^2V_{ig}/dt^2$ der gemessenen Spannung $V_{ig}$ ausgelöst wird.

8. Verfahren nach einem der vorhergehenden Ansprüche, ferner umfassend:

- eine Sammelschienenspannungsmessung vor der Flachbandspannung-$V_{fb,h+1}$-Extraktion, und
- eine Messung der Dauer des Anzustands und/oder der Dauer des Auszustands vor der Flachbandspannung-$V_{fb,h+1}$-Extraktion.

9. Verfahren nach einem der vorhergehenden Ansprüche, wobei die Serie von Betrieben wenigstens ein Mal wiederholt wird, um eine Flachbandevolution über die Zeit auszugeben.

10. Leistungshalbleitermodul (1), umfassend ein einzelnes Metalloxid-Halbleiter- oder ein einzelnes Metallisolator-Halbleiterelement oder eine Gruppe von Metalloxid-Halbleiterelementen oder eine Gruppe von Metallisolator-Halbleiterelementen oder eine Kombination von Metalloxid-Halbleiterelementen und Metallisolator-Halbleiterelementen, wobei das Modul ferner Messungsmittel umfasst, welche dazu eingerichtet sind, eine Spannung $V_{ig}$ über eine Stromquelle zu messen, und dazu angeordnet sind, das Verfahren nach einem der Ansprüche 1 bis 9 zu implementieren.

11. Computersoftware, welche Anweisungen zum Implementieren des Verfahrens nach einem der Ansprüche 1 bis 9 umfasst, wenn die Software durch einen Prozessor ausgeführt wird.

12. Computerlesbares nichtflüchtiges Aufnahmemedium, auf welchem eine Software registriert ist, um das Verfahren nach einem der Ansprüche 1 bis 9 zu implementieren, wenn die Software durch einen Prozessor ausgeführt wird.

**Revendications**

1. Procédé de mesure d'une tension en bande plate d'un module semi-conducteur de puissance (1) comprenant au moins un élément semi-conducteur (11) parmi un élément semi-conducteur métal-oxyde et un élément semi-conducteur métal-isolant pendant un service opérationnel, ledit procédé comprenant :

a. l'application d'une tension de polarisation audit module (1) de sorte que ledit module commute d'un état bloqué à un état passant, ou d'un état passant à un état bloqué ;
b. le déclenchement d'une injection de courant de grille $I_g$ d'une source de courant (44) à une grille du module lorsqu'une tension émetteur/source de grille initiale est égale à une tension en bande plate $V_{fb,h}$ du module dans les +/-5 V ;
c. la mesure de la tension $V_{ig}$ aux bornes de la source de courant ;
d. l'extraction d'une tension en bande plate $V_{fb,h+1}$ à partir de ladite tension $V_{ig}$ mesurée aux bornes de la source de courant
e. l'arrêt de ladite injection de courant de grille $I_g$

- lorsque la différence absolue entre la tension émetteur/source de grille et la tension en bande plate $V_{fb,h}$ devient supérieure à une limite prédéfinie ; ou
- lorsque la durée $t_{inj}$ d'injection de courant de grille $I_g$ dépasse une durée prédéterminée $t_{max}$ ;

f. la sauvegarde de la valeur de tension en bande plate $V_{fb,h+1}$ extraite.

2. Procédé selon la revendication 1, comprenant en outre :

- la mesurer d'une capacité $C_{meas}$ de l'au moins un élément semi-conducteur (11), et dans lequel la tension en bande plate $V_{fb,h+1}$ extraite est la tension $V_{ig}$ mesurée aux bornes de la source de courant déclenchée lorsqu'une transition entre une $C_{meas}$ constante et une $C_{meas}$ variable est détectée à partir de la mesure de capacité.

**3.** Procédé selon l'une des revendications précédentes, dans lequel le signe du courant de grille $I_g$ injecté dépend de l'état passant/bloqué de l'élément semi-conducteur (11).

**4.** Procédé selon la revendication 3, dans lequel

le courant de grille $I_g$ injecté est négatif
l'injection de courant de grille $I_g$ est arrêtée lorsque la tension $V_{ig}$ mesurée atteint une tension négative prédéterminée,
la dérivée temporelle de tension $dV_{ig}/dt$ est calculée et stockée d'une manière telle qu'elle peut être utilisée comme un paramètre d'entrée pour réitérer le procédé.

**5.** Procédé selon la revendication 4, dans lequel
si la dérivée temporelle de tension $dV_{ig}/dt$ calculée ne chute pas de plus d'une valeur relative prédéterminée, le procédé est alors réitéré avec un courant de grille $I_g$ injecté positif.

**6.** Procédé selon l'une des revendications précédentes, dans lequel le déclenchement d'injection de courant de grille $I_g$ est effectué :

- après un temps $t_p$ de la mise à l'état bloqué de l'élément semi-conducteur (11), et l'extraction d'une tension en bande plate $V_{fb, h+1}$ de polarisation de grille positive ; et/ou
- un temps $t_n$ avant la mise à l'état passant de l'élément semi-conducteur (11).

**7.** Procédé selon l'une des revendications précédentes, dans lequel la tension en bande plate $V_{fb,h+1}$ est extraite de ladite tension $V_{ig}$ mesurée aux bornes de la source de courant à un instant auquel une injection de courant de grille $I_g$ est déclenchée en réponse à une condition sur une dérivée temporelle seconde $d^2V_{ig}/dt^2$ de la tension $V_{ig}$ mesurée.

**8.** Procédé selon l'une des revendications précédentes, comprenant en outre :

- une mesure de tension de bus avant extraction de la tension en bande plate $V_{fb,h+1}$, et
- une mesure de la durée de l'état passant et/ou de la durée de l'état bloqué avant extraction de la tension en bande plate $V_{fb,h+1}$.

**9.** Procédé selon l'une des revendications précédentes, dans lequel la série d'opérations est réitérée au moins une fois de façon à délivrer en sortie une évolution de bande plate au cours du temps.

**10.** Module semi-conducteur de puissance (1) comprenant un unique semi-conducteur métal-oxyde ou un unique élément semi-conducteur métal-isolant ou un ensemble d'éléments semi-conducteurs métal-oxyde ou un ensemble d'éléments semi-conducteurs métal-isolant ou une combinaison d'éléments semi-conducteurs métal-oxyde et d'éléments semi-conducteurs métal-isolant, ledit module comprenant en outre des moyens de mesure adaptés pour mesurer une tension $V_{ig}$ aux bornes d'une source de courant et étant agencé pour mettre en œuvre le procédé selon l'une des revendications 1 à 9.

**11.** Logiciel d'ordinateur comprenant des instructions pour mettre en œuvre le procédé selon l'une des revendications 1 à 9 lorsque le logiciel est exécuté par un processeur.

**12.** Support d'enregistrement non transitoire lisible par ordinateur sur lequel un logiciel est inscrit pour mettre en œuvre le procédé selon l'une des revendications 1 à 9 lorsque le logiciel est exécuté par un processeur.

FIG. 1

EP 4 249 927 B1

FIG. 2

FIG. 3

**FIG. 4**

**FIG. 5**

**FIG. 6**

**FIG. 7**

FIG. 8

FIG. 9

EP 4 249 927 B1

FIG. 10

FIG. 11

FIG. 12

FIG. 13

FIG. 14

**REFERENCES CITED IN THE DESCRIPTION**

**Patent documents cited in the description**

- JP H09246340 A

**Non-patent literature cited in the description**

- **X. ZHONG**. Bias Temperature Instability of Silicon Carbide Power MOSFET Under AC Gate Stresses. *IEEE Transactions on Power Electronics*, February 2022, vol. 37 (2), 1998-2008
- **T. VANKAYALAPATI** ; **B. AKIN**. Temperature-Independent Gate-Oxide Degradation Monitoring of SiC MOSFETs Based on Junction Capacitances. *IEEE Transactions on Power Electronics*, July 2021, vol. 36 (7), 8308-8324

- **S. MBAREK** ; **F. FOUQUET** ; **P. DHERBECOURT** ; **M. MASMOUDI** ; **O. LATRY**. Gate oxide degradation of SiC MOSFET under short-circuit aging tests. *Microelectronics Reliability*, 2016, vol. 64, 415-418, https://doi.org/10.1016/j.microrel.2016.07.132